# FASCICULE DE BREVET EUROPEEN

(11) **EP 3 299 825 B1**
(45) Date de publication et mention de la délivrance du brevet: **10.08.2022**
(21) Numéro de dépôt: 17190673.8
(22) Date de dépôt: 12.09.2017
(51) Int. Cl.: G01R 19/00, B60L 3/12, G01R 21/00, G01R 31/00, G01R 15/14

(54) **SYSTEME DE MESURE DE LA CONSOMMATION ELECTRIQUE D'UN VEHICULE FERROVIAIRE ET VEHICULE FERROVIAIRE COMPRENANT UN TEL SYSTEME**
MESSSYSTEM DES STROMVERBRAUCHS EINES SCHIENENFAHRZEUGS, UND SCHIENENFAHRZEUG, DAS EIN SOLCHES SYSTEM UMFASST
SYSTEM FOR MEASURING THE ELECTRIC POWER CONSUMPTION OF A RAILWAY VEHICLE AND RAILWAY VEHICLE COMPRISING SUCH A SYSTEM

(30) Priorité: 23.09.2016 FR 1658982
(43) Date de publication de la demande: 28.03.2018
(73) Titulaire: SNCF Voyageurs, 93200 Saint-Denis (FR)
(72) Inventeur: COYAUD, Martin, 37000 Tours (FR); GALEB, Younes, 72000 Le Mans (FR); FRUGIER, Didier, 72100 Le Mans (FR)
(74) Mandataire: IPAZ

(56) Documents cités:
- EP-A2- 0 743 528
- WO-A2-2007/104464
- FR-A1- 2 912 699
- FR-A1- 2 965 058
- Unknown Unknown: "Using a Unity Gain Buffer (Voltage Follower) with a DAQ Device", , 30 janvier 2014 (2014-01-30), pages 1-4, XP055379963, Extrait de l'Internet: URL:http://www.ni.com/white-paper/4494/en/ [extrait le 2017-06-09]
- Rainer Parthier: "Verstärken" In: "Messtechnik - Grundlagen und Anwendungen der elektrischen Messtechnik", 23 août 2016 (2016-08-23), Springer Vieweg, XP055379980, ISBN: 978-3-658-13598-0 pages 162-163, DOI: 10.1007/978-3-658-13598, * le document en entier *

## Description

L'invention concerne un système de mesure de la consommation électrique d'un véhicule ferroviaire et un véhicule ferroviaire comprenant un tel système.

Le domaine de l'invention est le domaine des véhicules ferroviaires, tels que les trains, les train-tram ou les tramways, et plus précisément le domaine d'alimentation électrique de tels véhicules ferroviaires.

### ETAT DE LA TECHNIQUE

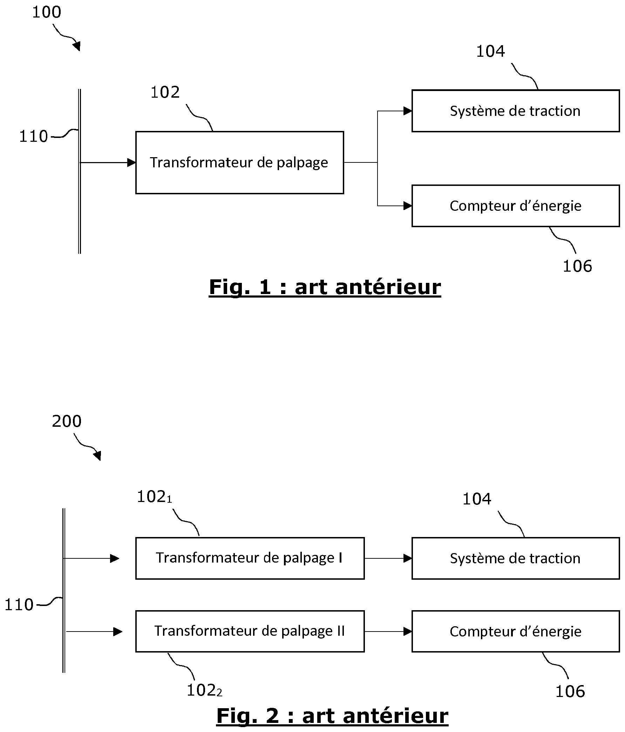

On connait les systèmes de mesure de la consommation électrique des véhicules ferroviaires, alimentés par une caténaire, comprenant un transformateur de palpage prévu pour palper la tension de la caténaire et informer le système de traction du véhicule ferroviaire des caractéristiques de la tension présente. Le document WO 2007/104464 A2 décrit un tel système. Ces systèmes de mesure caractérisent et mesurent la tension reçue de la caténaire afin d'estimer l'énergie consommée, à partir de la sortie du transformateur de palpage, pour des données de facturation par exemple. Ces systèmes de mesure (dont un exemple est représenté sur la FIGURE 1) partagent la sortie du transformateur de palpage pour le système de traction et le compteur d'énergie. Cependant, une surcharge ou une distorsion sur l'un des circuits de comptage d'énergie ou du système de traction diminue la précision du comptage d'énergie et/ou perturbe le circuit de traction, voire rend le système tiers inutilisable. D'autres systèmes de mesure (dont un exemple est représenté sur la FIGURE 2) utilisent un premier transformateur de palpage dédié au système de traction et un second transformateur de palpage dédié au comptage d'énergie. Cependant, cette solution est couteuse, encombrante et complexe à réaliser.

Un but de la présente invention est de remédier à ces inconvénients.

Un autre but de la présente invention est de proposer un système de mesure de la consommation électrique d'un véhicule ferroviaire permettant un comptage d'énergie plus précis.

Un autre but de la présente invention est de proposer un système de mesure de la consommation électrique d'un véhicule ferroviaire avec un circuit de traction plus fiable, notamment lors d'une perturbation sur le circuit de comptage d'énergie.

Un autre but de la présente invention est de proposer un système de mesure de la consommation électrique d'un véhicule ferroviaire moins couteux à réaliser.

Un autre but de la présente invention est de proposer un système de mesure de la consommation électrique d'un véhicule ferroviaire moins complexe à réaliser.

### EXPOSE DE L'INVENTION

Au moins un des objectifs précités est atteint par un système de mesure de la consommation électrique d'un véhicule ferroviaire d'un véhicule ferroviaire, alimenté par une caténaire, comprenant :
- au moins un transformateur de palpage pour convertir la tension de ladite caténaire et fournir un signal, dit de palpage, à un système de traction, et
- au moins un moyen de comptage d'énergie électrique fournie par ladite caténaire ;
caractérisé en ce qu'il comprend un répéteur comportant :
- une entrée reliée audit transformateur de palpage, pour recevoir ledit signal de palpage ; et
- deux sorties reliées, respectivement, audit moyen de comptage et audit système de traction, et fournissant des signaux électriques identiques entre eux et audit signal de palpage.

Avec le système selon l'invention, un seul transformateur de palpage est utilisé pour le comptage d'énergie et pour informer le système de traction du véhicule ferroviaire. Le coût et la complexité de réalisation sont ainsi réduits par rapports aux systèmes de l'état de la technique mettant en œuvre deux transformateurs de palpage.

De plus, les deux sorties du répéteur fournissent des signaux électriques identiques au signal de palpage, respectivement, au moyen de comptage d'énergie et au système de traction. Dans cette configuration, les influences mutuelles entre le moyen de comptage et le système de traction sont éliminées, du moins réduites. La précision du comptage d'énergie est ainsi améliorée et le système de traction fonctionne de façon plus fiable en comparaison avec les systèmes de l'état de l'art mettant en œuvre un même transformateur de palpage pour le circuit de traction et pour le moyen de comptage d'énergie.

En particulier, le répéteur reçoit à son entrée le signal de palpage fourni par le transformateur de palpage et le duplique pour émettre une copie dudit signal d'alimentation vers le moyen de comptage et une copie dudit signal vers le système de traction.

Selon l'invention, le répéteur a un gain unitaire entre son entrée et au moins une, en particulier chacune, de ses sorties.

Le répéteur délivre ainsi à chacune de ses sorties un signal identique à son entrée, c'est-à-dire, un signal identique au signal de palpage en entrée du répéteur.

Dans une version avantageuse, le système selon l'invention peut comprendre un court-circuit associé à un interrupteur commandable, agencé entre l'entrée du répéteur et la sortie du répéteur reliée au système de traction, prévu pour court-circuiter le moyen de comptage d'énergie et le répéteur.

Le court-circuit permet de relier le transformateur de palpage directement au système de traction. Cette disposition permet d'assurer la fonction de traction du véhicule ferroviaire dans le cas de panne du moyen de comptage d'énergie et/ou du répéteur. Le système selon l'invention offre ainsi un véhicule ferroviaire plus disponible.

Avantageusement, le système selon l'invention peut comprendre un moyen de commande manuel pour activer et/ou désactiver le court-circuit, tel qu'un bouton de commande mécanique par exemple.

Le moyen de commande manuel peut permettre à un utilisateur d'activer et/ou de désactiver le court-circuit de façon manuelle, en cas de besoin.

Dans un mode de réalisation, le système selon l'invention peut comprendre un moyen de commande automatique pour activer et/ou désactiver le court-circuit en fonction :
- d'un signal relatif audit moyen de comptage,
- d'un signal relatif audit répéteur, et/ou
- d'un signal de commande émis par un dispositif externe.

Le moyen de commande peut recevoir chacun de ces signaux de manière filaire ou sans fil. Par exemple, le moyen de commande peut comprendre un moyen de communication filaire, ou sans fil, et au moins un relai électromécanique.

Ainsi, le moyen de commande automatique peut permettre l'activation du court-circuit dans le cas de pannes sur le moyen de comptage et/ou le répéteur.

En particulier, le moyen de commande automatique peut permettre l'activation et/ou la désactivation du court-circuit à distance par un utilisateur.

Dans un mode de réalisation préférée, le répéteur peut avoir une impédance d'entrée infinie, en particulier supérieure ou égale à 10kohms.

L'impédance très élevée du répéteur peut éviter de perturber et/ou de surchager le transformateur de palpage, lorsqu'une anomalie intervient au niveau d'au moins une, en particulier de chacune, de ses sorties. Ainsi, le fonctionnement du transformateur de palpage est préservé en cas de panne ou de surcharge sur le circuit du moyen de comptage et/ou le système de traction.

Suivant un mode de réalisation du système selon l'invention, le répéteur peut comprendre un amplificateur opérationnel avec un gain unitaire.

Suivant un autre aspect de l'invention, il est proposé un véhicule ferroviaire comprenant un système de mesure de la consommation électrique selon l'invention.

Un tel véhicule peut être un train, un train-tram, un tramway, une locomotive, une motrice, etc.

### DESCRIPTION DES FIGURES ET MODES DE REALISATION

D'autres avantages et caractéristiques apparaîtront à l'examen de la description détaillée d'exemples nullement limitatifs, et des dessins annexés sur lesquels :
- la FIGURE 1 est une représentation schématique d'un premier exemple de système d'alimentation de l'art antérieur ;
- la FIGURE 2 est une représentation schématique d'un deuxième exemple de système d'alimentation de l'art antérieur ;
- la FIGURE 3 est une représentation schématique d'un premier exemple du système selon l'invention, et
- la FIGURE 4 est une représentation schématique d'un exemple de réalisation non limitatif d'un répéteur pouvant être mis en œuvre dans le système selon l'invention.

Il est bien entendu que les modes de réalisation qui seront décrits dans la suite ne sont nullement limitatifs. On pourra notamment imaginer des variantes de l'invention ne comprenant qu'une sélection de caractéristiques décrites par la suite isolées des autres caractéristiques décrites, si cette sélection de caractéristiques est suffisante pour conférer un avantage technique ou pour différencier l'invention par rapport à l'état de la technique antérieure. Cette sélection comprend au moins une caractéristique de préférence fonctionnelle sans détail structurel, ou avec seulement une partie des détails structurels si cette partie uniquement est suffisante pour conférer un avantage technique ou pour différencier l'invention par rapport à l'état de la technique antérieure.

En particulier toutes les variantes et tous les modes de réalisation décrits sont combinables entre eux si rien ne s'oppose à cette combinaison sur le plan technique.

Sur les figures, les éléments communs à plusieurs figures conservent la même référence.

La FIGURE 1 est une représentation schématique d'un premier exemple de système de mesure de la consommation électrique, de l'art antérieur.

Le système 100, représenté sur la FIGURE 1, comprend un transformateur de palpage 102 pour convertir la tension reçue d'une caténaire 110.

La sortie du transformateur de palpage 102 est partagée pour fournir un signal de palpage, également appelé signal de mesure, d'une part à un système de de traction 104 du véhicule ferroviaire et d'autre part à un moyen de comptage d'énergie 106.

La FIGURE 2 est une représentation schématique d'un deuxième exemple de système de mesure de la consommation électrique d'un véhicule ferroviaire, de l'art antérieur.

Le système 200, représenté sur la FIGURE 2, comprend deux transformateurs de palpage 102₁-102₂ pour palper la tension reçue de la caténaire 110.

Le transformateur de palpage 102₁ fournit un signal de mesure au système de traction 104 du véhicule ferroviaire, tandis que le transformateur de palpage 102₁ fournit un signal de mesure au moyen de comptage d'énergie 106.

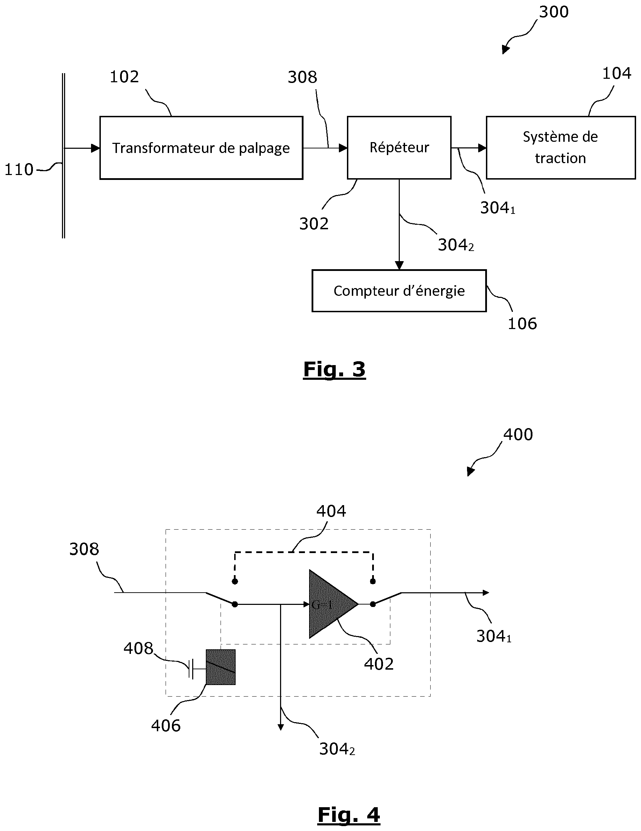

La FIGURE 3 est une représentation schématique d'un exemple de réalisation non limitatif d'un système de mesure de la consommation électrique d'un véhicule ferroviaire, selon l'invention.

Le système 300, représenté sur la FIGURE 3, comprend le transformateur de palpage 102 relié à une entrée 308 d'un répéteur 302.

Le répéteur 302 possède deux sorties 304₁-304₂ fournissant chacune un signal identique au signal de palpage (ou signal de mesure) en sortie du transformateur de palpage 102.

La première sortie 304₁ du répéteur 302 est reliée au système de traction 104 du véhicule ferroviaire. La seconde sortie 304₂ du répéteur 302 est reliée au moyen de comptage d'énergie 106.

En particulier, le répéteur 302 reçoit en entrée 308 le signal électrique émis par le transformateur de palpage et duplique ce signal pour l'émettre d'une part sur sa sortie 304₁ à destination du système de traction 104 et d'autre part sur sa sortie 304₂ à destination du compteur d'énergie 106.

La FIGURE 4 est une représentation schématique d'un exemple de réalisation non limitatif d'un répéteur pouvant être mis en œuvre dans le système selon l'invention.

En particulier, le répéteur représenté sur la FIGURE 4, peut être le répéteur 302 de la FIGURE 3.

Le répéteur 400 comprend donc les sorties 304₁ et 304₂ fournissant un signal identique au signal reçu à son entrée 308.

Tel que représenté sur la FIGURE 4, le répéteur 400 comprend un amplificateur opérationnel 402 ayant un gain unitaire, une résistance infinie à son entrée, et une résistance nulle à sa sortie 304₁ reliée au système de traction 104.

Le répéteur 400 comprend en outre un court-circuit 404, agencé entre l'entrée 308 du répéteur 400 et sa sortie 304₁. Le court-circuit 404 permet de relier l'entrée 308 directement à la sortie 304₁ et simultanément de déconnecter le répéteur 400 et la sortie 304₂, en particulier en cas de panne ou de perturbation des composants du répéteur 400 et/ou de la sortie 304₂.

Le répéteur 400 est aussi équipé d'un moyen de commande 406 du court-circuit 404. Le moyen de commande 406 comprend une antenne 408 pour recevoir et/ou transmettre des données depuis/vers un dispositif distant. Alternativement, ou en plus, le moyen de commande peut en outre comprendre une ou plusieurs interfaces filaires pour recevoir des données.

Le moyen de commande 406 reçoit des données relatives au répéteur 400, à ses sorties 304 et à son entrée 308, ou des données relatives à l'un quelconque des composants se trouvant entre l'entrée 308 et sa sortie 304₁. En fonction des données reçues, le moyen de commande active ou désactive le court-circuit 404. En particulier, le moyen de commande 408 active le court-circuit 404 en cas de pannes ou de perturbations du répéteur 400 ou du compteur d'énergie 106.

Alternativement, le moyen de commande 406 peut recevoir des données de commande d'un utilisateur, ou d'un dispositif externe, pour activer/désactiver le court-circuit 404.

Lorsque le court-circuit 404 est activé, le signal de palpage fournit par le transformateur de palpage est fourni au système de traction 104 directement par le transformateur de palpage 102 en reliant l'entrée 308 à la sortie 304₁, par exemple en cas de panne ou de perturbation du répéteur 400 et/ou du moyen du comptage d'énergie 106.

Bien sûr, l'invention n'est pas limitée aux exemples qui viennent d'être décrits et de nombreux aménagements peuvent être apportés à ces exemples sans sortir du cadre de l'invention, qui est défini par les revendications annexées.

## Revendications

1. Système de mesure de la consommation électrique (300) d'un véhicule ferroviaire, alimenté par une caténaire (110), comprenant :
- au moins un transformateur de palpage (102) pour convertir la tension de ladite caténaire (110) et fournir un signal, dit de palpage, à un système de traction (104), et
- au moins un moyen de comptage (106) d'énergie électrique fournie par ladite caténaire (110) ;
**caractérisé en ce qu'**il comprend un répéteur (302,400) comportant :
- une entrée (308) reliée audit transformateur de palpage (102), pour recevoir ledit signal de palpage ; et
- deux sorties (304₁,304₂) reliées, respectivement, audit moyen de comptage (106) et audit système de traction (104), et fournissant des signaux électriques identiques entre eux et audit signal de palpage,
le répéteur (302,400) ayant un gain unitaire entre son entrée (308) et au moins une, en particulier chacune, de ses sorties (304₁,304₂).

2. Système (300) selon la revendication 1, **caractérisé en ce qu'**il comprend un court-circuit (404) associé à un interrupteur commandable, agencé entre l'entrée (308) du répéteur (302,400) et la sortie (304₁) du répéteur (302,400) reliée au système de traction (104), prévu pour court-circuiter le moyen de comptage d'énergie (106) et le répéteur (302,400).

3. Système (300) selon la revendication précédente, **caractérisé en ce qu'**il comprend un moyen de commande manuel pour activer et/ou désactiver le court-circuit (404).

4. Système (300) selon l'une quelconque des revendications 2 ou 3, **caractérisé en ce qu'**il comprend un moyen de commande automatique (406) pour activer et/ou désactiver le court-circuit (404) en fonction :
- d'un signal relatif audit moyen de comptage (106),
- d'un signal relatif audit répéteur (302,400), et/ou
- d'un signal de commande émis par un dispositif externe.

5. Système (300) selon l'une quelconque des revendications précédentes, **caractérisé en ce que** le répéteur (302,400) a une impédance d'entrée infinie, en particulier supérieure ou égale à 10 kOhms.

6. Système (300) selon l'une quelconque des revendications précédentes, **caractérisé en ce que** le répéteur (400) comprend un amplificateur opérationnel (402) avec un gain unitaire.

7. Véhicule ferroviaire comprenant un système de mesure de la consommation électrique (300) selon l'une quelconque des revendications précédentes.

## Patentansprüche

1. Elektrizitätsverbrauchsmesssystem (300) eines Gleisfahrzeugs, das durch eine Fahrleitung (110) versorgt wird, umfassend:
- mindestens einen Abtasttransformator (102) zum Umwandeln der Spannung der Fahrleitung (110) und Bereitstellen eines sogenannten Abtastsignals an ein Antriebssystem (104), und
- mindestens ein Zählmittel (106) für elektrische Energie, die durch die Fahrleitung (110) bereitgestellt wird;
**dadurch gekennzeichnet, dass** es einen Zwischenverstärker (302, 400) umfasst, umfassend:
- einen Eingang (30), der mit dem Abtasttransformator (102) verbunden ist, zum Empfangen des Abtastsignals; und
- zwei Ausgänge (304₁, 304₂ ), die jeweils mit dem Zählmittel (106) und mit dem Antriebssystem (104) verbunden sind und elektrische Signale bereitstellen, die untereinander und mit dem Abtastsignal identisch sind,
wobei der Zwischenverstärker (302, 400) eine Einheitsverstärkung zwischen seinem Eingang (308) und mindestens einem, insbesondere jedem seiner Ausgänge (304₁, 304₂ ) aufweist.

2. System (300) nach Anspruch 1, **dadurch gekennzeichnet, dass** es einen Kurzschluss (404) umfasst, der einem steuerbaren Ausschalter zugehörig ist, der zwischen dem Eingang (308) des Zwischenverstärkers (302, 400) und dem Ausgang (304₁) des Zwischenverstärkers (302,400) angeordnet ist, der mit dem Antriebssystem (104) verbunden ist, der zum Kurzschließen des Energiezählmittels (106) und des Zwischenverstärkers (302, 400) vorgesehen ist.

3. System (300) nach dem vorhergehenden Anspruch, **dadurch gekennzeichnet, dass** es ein manuelles Steuermittel zum Aktivieren und/oder Deaktivieren des Kurzschlusses (404) umfasst.

4. System (300) nach einem der Ansprüche 2 oder 3, **dadurch gekennzeichnet, dass** es ein automatisches Steuermittel (406) zum Aktivieren und/oder Deaktivieren des Kurzschlusses (404) umfasst, in Abhängigkeit von:
- einem Signal, das sich auf das Zählmittel (106) bezieht,
- einem Signal, das sich auf den Zwischenverstärker (302, 400) bezieht, und/oder
- einem Steuersignal das durch eine externe Vorrichtung ausgegeben wird.

5. System (300) nach einem der vorhergehenden Ansprüche, **dadurch gekennzeichnet, dass** der Zwischenverstärker (302,400) eine unendliche Eingangsimpedanz, insbesondere größer als oder gleich 10 kOhm aufweist.

6. System (300) nach einem der vorhergehenden Ansprüche, **dadurch gekennzeichnet, dass** der Zwischenverstärker (400) einen Betriebsverstärker (402) mit einer Einheitsverstärkung umfasst.

7. Gleisfahrzeug, umfassend ein Elektrizitätsverbrauchsmesssystem (300) nach einem der vorhergehenden Ansprüche.

## Claims

1. System (300) for measuring the electrical consumption of a railway vehicle powered by an overhead contact line (110), comprising:
- at least one sensing transformer (102) for converting the voltage of said overhead contact line (110) and supplying a signal, referred to as the sensing signal, to a traction system (104), and
- at least one means (106) for metering electrical energy supplied by said overhead contact line (110);
**characterized in that** it comprises a repeater (302, 400) comprising:
- an input (308) connected to said sensing transformer (102), for receiving said sensing signal; and
- two outputs (304₁, 304₂) which are connected, respectively, to said metering means (106) and to said traction system (104), and which supply electrical signals that are identical to each other and to said sensing signal,
the repeater (302, 400) having a unity gain between its input (308) and at least one, in particular each, of its outputs (304₁, 304₂).

2. System (300) according to claim 1, **characterized in that** it comprises a short circuit (404) which is associated with a controllable switch, is arranged between the input (308) of the repeater (302, 400) and the output (304₁) of the repeater (302, 400) connected to the traction system (104), and is provided to short-circuit the energy metering means (106) and the repeater (302, 400).

3. System (300) according to the preceding claim, **characterized in that** it comprises a manual control means for activating and/or deactivating the short circuit (404).

4. System (300) according to either claim 2 or claim 3, **characterized in that** it comprises an automatic control means (406) for activating and/or deactivating the short circuit (404) on the basis of:
- a signal relating to said metering means (106),
- a signal relating to said repeater (302, 400), and/or
- a control signal emitted by an external device.

5. System (300) according to any of the preceding claims, **characterized in that** the repeater (302, 400) has an infinite input impedance, in particular greater than or equal to 10 kOhms.

6. System (300) according to any of the preceding claims, **characterized in that** the repeater (400) comprises a operational amplifier (402) having a unity gain.

7. Railway vehicle comprising an electrical consumption measurement system (300) according to any of the preceding claims.
